# EUROPEAN PATENT APPLICATION

(11) **EP 4 656 927 A1**
(43) Date of publication of application: **03.12.2025**
(21) Application number: 25179676.9
(22) Date of filing: 29.05.2025
(51) Int. Cl.: F16M 11/22, F16M 13/02, H04N 5/64, A47B 97/00

(54) **BRACKET ASSEMBLY AND DISPLAY DEVICE COMPRISING THE SAME**

(30) Priority: 30.05.2024 KR 20240070762
(71) Applicant: LG Electronics Inc., Yeongdeungpo-gu Seoul 07336 (KR)
(72) Inventor: KIM, Yoonsu, 07796 Seoul (KR); HONG, Sungwan, 07796 Seoul (KR)
(74) Representative: Vossius & Partner Patentanwälte Rechtsanwälte mbB

(57) **Abstract**

A bracket assembly suitable for supporting a display device comprising a front bracket and a rear bracket, wherein the front bracket comprises a front horizontal plate configured to support a bottom of the display device; a front vertical plate angled and extending from the front horizontal plate so as to be positioned at a rear of the display device; and a hook at a rear surface of the front vertical plate, and wherein the rear bracket comprises a rear horizontal plate configured to support the front horizontal plate; a rear vertical plate angled and extending from the rear horizontal plate so as to face the front vertical plate; and a coupling portion formed at the rear vertical plate and configured to allow the hook of the front bracket to be inserted therein so as to be moveable in a left-and-right direction.

## Description

### BACKGROUND

### 1. Field

The present disclosure relates to a bracket assembly and a display device including the bracket assembly. More particularly, the present disclosure relates to a bracket assembly used in a display device including a transparent display panel.

### 2. Description of the Related Art

With the development of information society, there has been a growing demand for various types of display devices. In order to meet such demand, various display devices, such as a liquid crystal display (LCD), a plasma display panel (PDP), an electro luminescent display (ELD), a vacuum fluorescent display (VFD), an organic light emitting diode (OLED) display, and the like, have been developed and used.

Among them, an LCD panel includes a TFT substrate and a color substrate that face each other with a liquid crystal layer interposed therebetween, so as to display an image using light provided from a backlight unit. Meanwhile, an OLED panel can display an image by depositing a self-luminescent organic layer on a substrate having a transparent electrode formed thereon.

Recently, numerous research has been conducted on a transparent (or see-through) display panel that allows users to view an image displayed thereon while being able to see what's behind the display panel.

### SUMMARY

It is an objective of the present disclosure to solve the above and other problems.

It is another objective of the present disclosure to provide a display device having a transparent display panel.

It is yet another objective of the present disclosure to provide a bracket assembly for fixing a transparent display device.

It is yet another objective of the present disclosure to provide a bracket assembly that allows fine adjustment of the position of a transparent display device.

According to one aspect of the subject matter described in this application, a bracket assembly includes: a front bracket to support a display device including a display panel; and a rear bracket to support the front bracket, wherein the front bracket includes: a horizontal plate to support a bottom of the display device; a vertical plate bent and extending from the horizontal plate of the front bracket so as to be positioned at a rear of the display device; and a hook fixed to a rear surface of the vertical plate of the front bracket, and the rear bracket includes: a horizontal plate to support the horizontal plate of the front bracket; a vertical plate bent and extending from the horizontal plate of the rear bracket, the vertical plate facing the vertical plate of the front bracket; and a coupling portion formed on the vertical plate of the rear bracket, the coupling portion being configured to allow the hook of the front bracket to be inserted therein so as to be moveable in a left-and-right direction.

According to another aspect, a display device includes: a display including a transparent display panel configured to display an image and a transparent panel to which the transparent display panel is coupled; a side frame to which the display is coupled; a housing to which the side frame is coupled; a middle frame to support the housing; a top frame disposed opposite the middle frame with respect to the display; a plurality of vertical frames to connect the top frame and the middle frame; a front bracket to support the middle frame; and a rear bracket to which the front bracket is coupled.

A display device according to the present disclosure has the following effects.

According to at least one of the embodiments of the present disclosure, it is possible to provide a display device having a transparent display panel.

According to at least one of the embodiments of the present disclosure, it is possible to provide a bracket assembly for fixing a transparent display device.

According to at least one of the embodiments of the present disclosure, it is possible to provide a bracket assembly that allows fine adjustment of the position of a transparent display device.

Further scope of applicability of the present disclosure will become apparent from the following detailed description. It should be understood, however, that the configurations in the detailed description are given by way of illustration only, since various changes and modifications within the idea and scope of the present disclosure will be apparent to those skilled in the art.

### BRIEF DESCRIPTION OF THE DRAWINGS

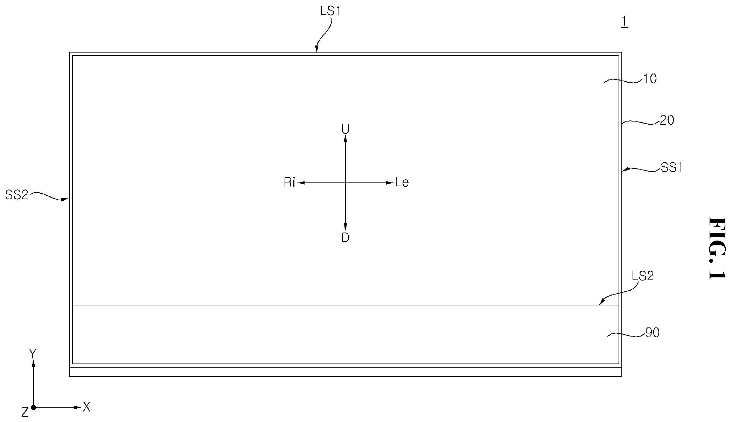

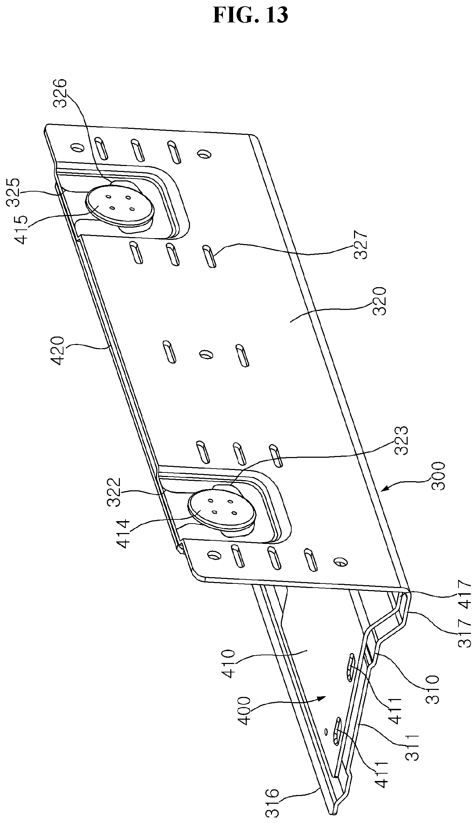

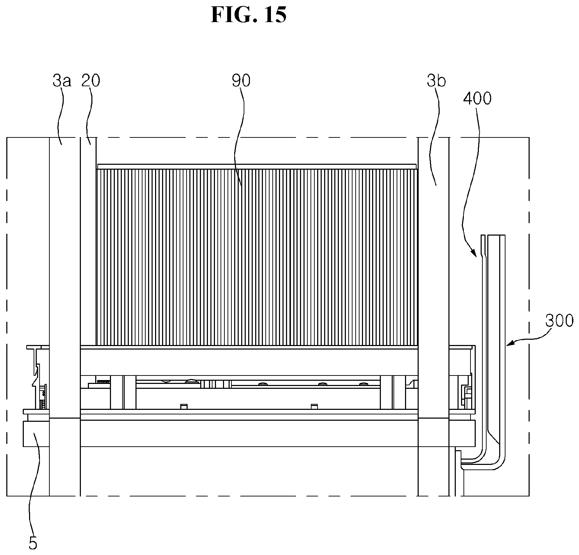

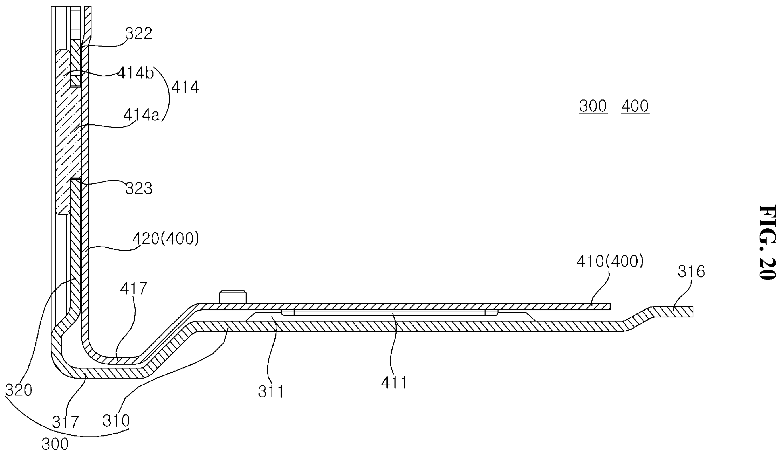

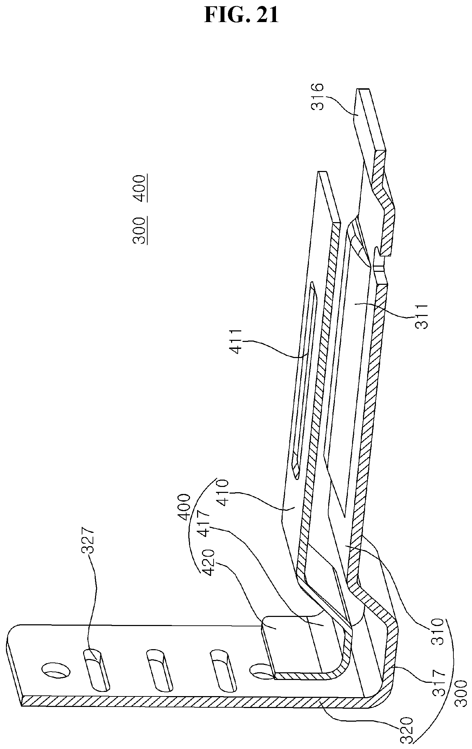

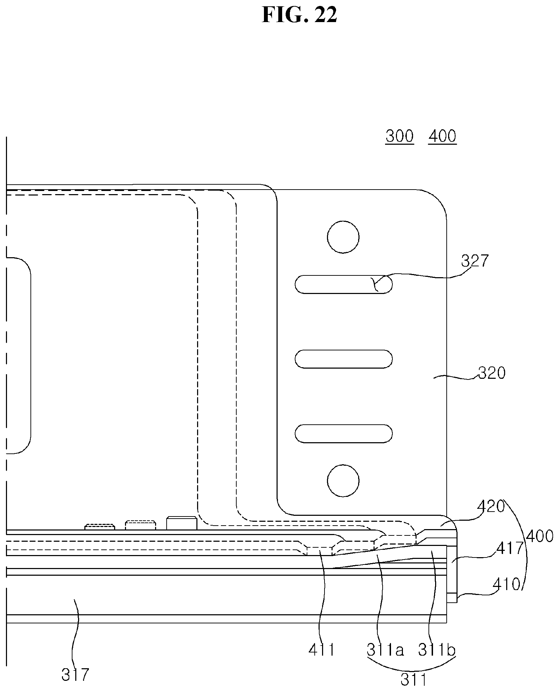

FIGS. 1 to 30 illustrate examples of a bracket assembly and a display device including the bracket assembly, according to embodiments of the present disclosure.

### DETAILED DESCRIPTION

Description will now be given in detail according to exemplary embodiments disclosed herein, with reference to the accompanying drawings. For the sake of brief description with reference to the drawings, the same or equivalent components may be denoted by the same reference numbers, and description thereof will not be repeated.

In the following description, a suffix such as "module" and "unit" may be used to refer to elements or components. Use of such a suffix herein is merely intended to facilitate description of the specification, and the suffix itself is not intended to give any special meaning or function.

In the present disclosure, that which is well known to one of ordinary skill in the relevant art has generally been omitted for the sake of brevity. The accompanying drawings are used to help easily understand the technical idea of the present disclosure and it should be understood that the idea of the present disclosure is not limited by the accompanying drawings. The idea of the present disclosure should be construed to extend to any alterations, equivalents, and substitutes besides the accompanying drawings.

Although the terms "first", "second", etc. may be used herein to describe various elements, these elements should not be limited by these terms. These terms are only used to distinguish one element from another.

It will be understood that when a component is referred to as being "connected to" or "coupled to" another component, it may be directly connected to or coupled to another component, or intervening components may be present. **In** contrast, when a component is referred to as being "directly connected to" or "directly coupled to" another component, there are no intervening components present.

As used herein, a singular representation is intended to include a plural representation unless the context clearly indicates otherwise.

It will be further understood that the terms "comprises or includes" and/or "has" when used in this specification, specify the presence of a stated feature, number, step, operation, component, element, or combination thereof, but do not preclude the presence or addition of one or more other features, numbers, steps, operations, components, elements, or combinations thereof.

The directions "up (U)", "down (D)", "left (Le)", "right (Ri)", "front (F)", and "rear (R)" shown in the drawings are only for the convenience of description, and the technical concept disclosed in the specification is not limited by these directions.

Referring to FIG. 1, a display device 1 may include a display 10, a side frame 20, and a housing 90. The display 10 may display an image. The side frame 20 may extend along a periphery of the display 10. The housing 90 may be positioned under the display 10 and the side frame 20. Alternatively, the housing 90 may be positioned at the top, left, or bottom of the display 10 and the side frame 20.

The display 10 may include a first long side LS1, a second long side LS2 opposite the first long side LS1, a first short side SS1 adjacent to the first long side LS1 and the second long side LS2, and a second short side SS2 opposite the first short side SS1.

Meanwhile, for ease of explanation, it is illustrated and described that lengths of the first and second long sides LS1 and LS2 are greater than lengths of the first and second short sides SS1 and SS2, but the lengths of the first and second long sides LS1 and LS2 may be substantially equal to the lengths of the first and second short sides SS1 and SS2.

A direction parallel to the long sides LS1 and LS2 of the display 10 may be referred to as a left-and-right direction. A direction parallel to the short sides SS1 and SS2 of the display 10 may be referred to as an up-and-down direction. A direction perpendicular to the long sides LS1 and LS2 and the short sides SS1 and SS2 of the display 10 may be referred to as a front-and-rear direction.

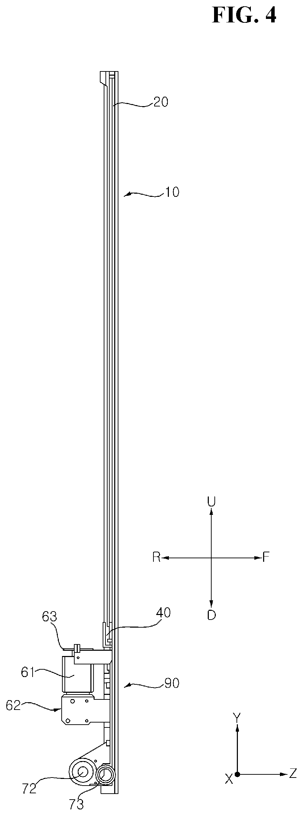

A direction in which the display 10 displays an image may be referred to as a front (F, z) (see FIG. 4), and a direction opposite to the front may be referred to as a rear (R, -z) (see FIG. 4). The first short side SS1 may be referred to as a left side (Le, x). The second short side SS2 may be referred to as a right side (Ri, -x). The first long side LS1 may be referred to as an upper side (U, y). The second long side LS2 may be referred to as a lower side (D, -y).

In the following description, a display panel using an organic light emitting diode (OLED) will be used as an example, but the display panel applicable to the present disclosure is not limited thereto.

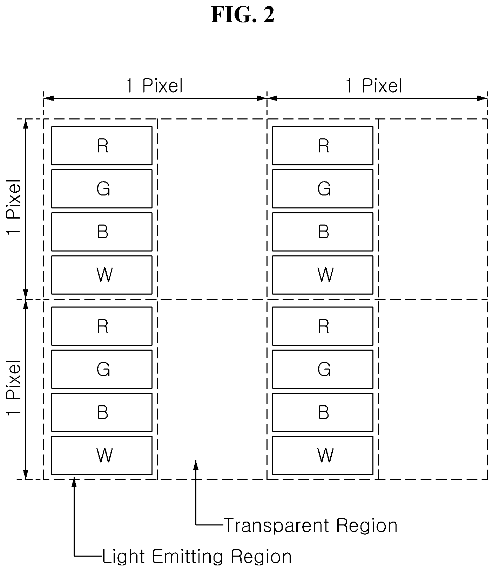

Referring to FIG. 2, a pixel may include a light emitting region and a transparent region. RGBW (Red, Green, Blue, White) subpixels may be arranged vertically in the light emitting region, and the transparent region with no subpixels may be disposed next to the light emitting region.

Thus, the display panel including a plurality of pixels may not only display an image but also allow light to pass therethrough. The display panel may be referred to as a transparent display panel or a transparent OLED panel.

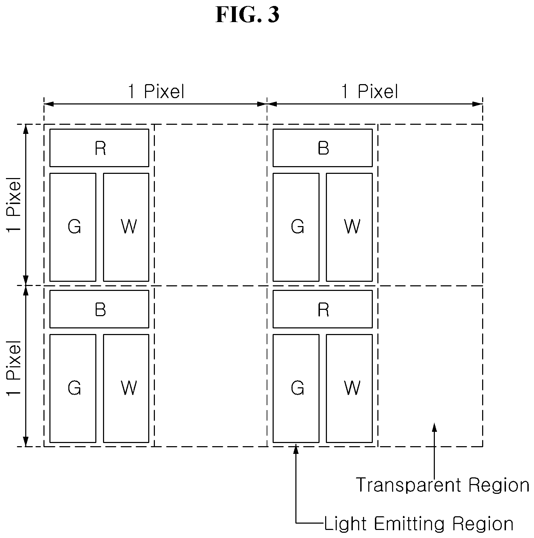

Referring to FIG. 3, a pixel may include a light emitting region and a transparent region. RGW (Red, Green, White) subpixels or BGW (Blue, Green, White) subpixels may be arranged adjacent to each other in the light emitting region, and the transparent region with no subpixels may be disposed next to the light emitting region.

Thus, the display panel including a plurality of pixels may not only display an image but also allow light to pass therethrough. The display panel may be referred to as a transparent display panel or a transparent OLED panel.

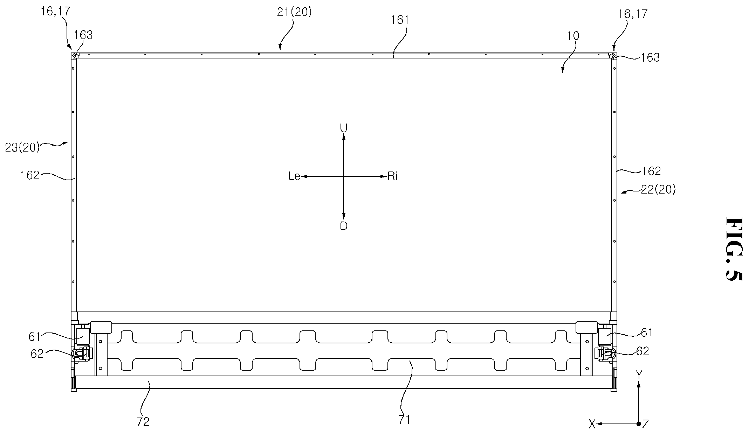

Referring to FIGS. 4 and 5, the display 10 may include a transparent display panel and a transparent panel. For example, the transparent display panel may be coupled or bonded to the transparent panel.

The display 10 may be coupled to the side frame 20. The housing 90 may include a housing frame 71. The housing frame 71 may be coupled or fixed to the side frame 20. The housing frame 71 may cover a rear surface of the display 10. The housing frame 71 may be positioned at the rear of the display 10. The housing frame 71 may be referred to as a rear frame 71, a rear plate 71, or a rear base 71. A length of the housing frame 71 may correspond to the long side of the display 10. A width of the housing frame 71 may be less than the short side of the display 10.

A motor 61 may be provided in plurality. The plurality of motors 61 may be disposed at the rear of the display 10 while being respectively adjacent to the left side and the right side of the display 10. A pair of motors 61 may provide dual driving force. A gear box 62 may correspond to the motor 61. A plurality of gear boxes 62 may be connected to the plurality of motors 61, respectively. A pair of gear boxes 62 may transmit the dual driving force provided by the pair of motors 61. The motor 61 and/or the gear box 62 may be coupled or fixed to a rear surface of the housing frame 71. Owing to the housing frame 71, the motor 61 and/or the gear box 62 may not be exposed at the front of the display device 1. A bar 40 may move up and down while sliding on the side frame 20.

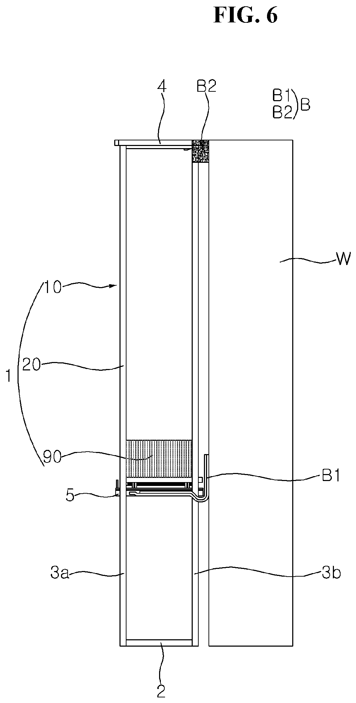

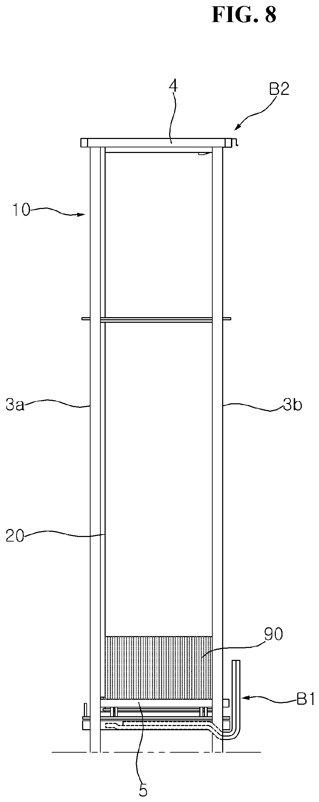

Referring to FIGS. 6 and 8, the display device 1 (see FIG. 1) may be coupled to a shelf. The shelf may lean against a wall W or may be positioned next to the wall W. The shelf may include a bottom frame 2, a top frame 4, a middle frame 5, and vertical frames 3a and 3b. The vertical frames 3a and 3b may be coupled or fixed to the bottom frame 2. The top frame 4 may connect upper ends of the vertical frames 3a and 3b or may fix the upper ends of the vertical frames 3a and 3b to each other. The middle frame 5 may be positioned between the bottom frame 2 and the top frame 4, and may be coupled or fixed to the vertical frames 3a and 3b.

The housing 90 of the display device 1 (see FIG. 1) may be placed on the middle frame 5. The housing 90 may be coupled or fixed to the middle frame 5. The display 10 and/or the side frame 20 may be coupled or fixed to the vertical frames 3a and 3b.

The display device 1 (see FIG. 1) placed on or coupled to the shelf may allow the center of gravity of the shelf to be located closer to the middle frame 4 than the top frame 4, between the middle frame 5 and the top frame 4. When an external force is applied to the display device 1 (see FIG. 1) and/or the shelf, it may cause the display device 1 (see FIG. 1) and/or the shelf to fall down or be turned over.

A bracket assembly B may connect or secure the display device 1 (see FIG. 1) and/or the shelf to the wall W. The bracket assembly B may include a lower bracket assembly B1 and an upper bracket assembly B2. The lower bracket assembly B1 may be referred to as a main bracket assembly B1. The upper bracket assembly B2 may be referred to as a sub bracket assembly B2.

The lower bracket assembly B1 may be coupled or fixed to the middle frame 5 and/or the housing 90. The upper bracket assembly B2 may be coupled or fixed to the upper part of the top frame 4 and/or the vertical frames 3a and 3b. Thus, it is possible to prevent the display 1 (see FIG. 1) and/or the shelf from being turned over or falling down.

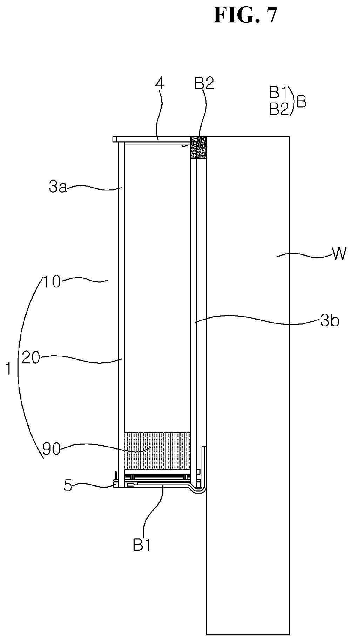

Referring to FIGS. 7 and 8, the display device 1 (see FIG. 1) may be coupled to a shelf. The shelf may lean against a wall W or may be hung on the wall W. The shelf may include a top frame 4, a middle frame 5, and vertical frames 3a and 3b. The top frame 4 may connect upper ends of the vertical frames 3a and 3b or may fix the upper ends of the vertical frames 3a and 3b to each other. The middle frame 5 may connect lower ends of the vertical frames 3a and 3b, or may be coupled or fixed to the lower ends of the vertical frames 3a and 3b.

The housing 90 of the display device 1 (see FIG. 1) may be placed on the middle frame 5. The housing 90 may be coupled or fixed to the middle frame 5. The display 10 and/or the side frame 20 may be coupled or fixed to the vertical frames 3a and 3b.

The display device 1 (see FIG. 1) placed on or coupled to the shelf may allow the center of gravity of the shelf to be located closer to the middle frame 5 than the top frame 4, between the middle frame 5 and the top frame 4. When an external force is applied to the display device 1 (see FIG. 1) and/or the shelf, it may cause the separation of the display device 1 (see FIG. 1) and/or the shelf from the wall W.

A bracket assembly B may connect or secure the display device 1 (see FIG. 1) and/or the shelf to the wall W. The bracket assembly B may include a lower bracket assembly B1 and an upper bracket assembly B2. The lower bracket assembly B1 may be referred to as a main bracket assembly B1. The upper bracket assembly B2 may be referred to as a sub bracket assembly B2.

The lower bracket assembly B1 may be coupled or fixed to the middle frame 5 and/or the housing 90. The upper bracket assembly B2 may be coupled to the upper part of the top frame 4 and/or the vertical frames 3a and 3b. Thus, it is possible to prevent the display 1 (see FIG. 1) and/or the shelf from being turned over or falling down.

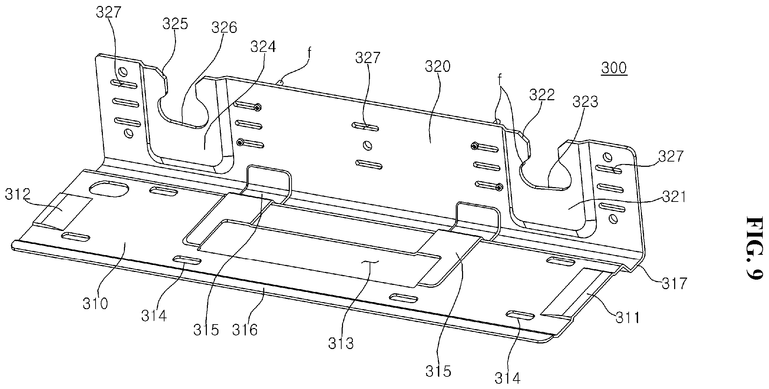

Referring to FIG. 9, the lower bracket assembly B1 (see FIG. 8) may include a rear backet 300. The rear bracket 300 may be referred to as an outer bracket 300. The rear bracket 300 may include a horizontal plate 310 and a vertical plate 320. The vertical plate 320 may be connected to the horizontal plate 310 while being bent from the horizontal plate 310. A flat (or planar) surface of the vertical plate 320 may be perpendicular to a flat surface of the horizontal plate 310.

The horizontal plate 310 may be an elongated plate. The horizontal plate 310 may include an inclined portion (311, 312). A plurality of inclined portions 311 and 312 may be provided. The plurality of inclined portions 311 and 312 may be formed while being respectively adjacent to edges at both ends in a longitudinal direction of the horizontal plate 310. The inclined portion 311, 312 may be formed by pressing the horizontal plate 310. The inclined portion 311, 312 may protrude from an upper surface of the horizontal plate 310.

The horizontal plate 310 may include an opening 313. The opening 313 may be formed through the upper and lower surfaces of the horizontal plate 310 between a pair of inclined portions 311 and 312. The opening 313 may have a quadrangular shape elongated in the longitudinal direction of the horizontal plate 310. The opening 313 may be referred to as a lower heat dissipation hole 313 or a first heat dissipation hole 313.

The horizontal plate 310 may include long holes 314. The long holes 314 may be formed through the horizontal plate 310. The horizontal plate 310 may include a front step 316. The front step 316 may be formed by pressing the horizontal plate 310 adjacent to a long side of the horizontal plate 310. The front step 316 may form a step descending from the front to the rear of the horizontal plate 310.

The rear bracket 300 may include a trench 317. The trench 317 may define a corner of the horizontal plate 310 and the vertical plate 320. The trench 317 may be formed by being lowered or recessed from the upper surface of the horizontal plate 310, and may be connected to the vertical plate 320.

The vertical plate 320 may include a coupling portion (321, 324). A plurality of coupling portions 321 and 324 may be provided. The opening 313 of the horizontal plate 310 may be positioned between a pair of coupling portions 321 and 324. The coupling portion 321, 324 may be formed by pressing the vertical plate 320 from the rear to the front. The coupling portion 321, 324 may include an insertion guide 322, 325 and an alignment hole 323, 326. The insertion guide 322, 325 may be formed by cutting out a portion of the vertical plate 320, namely, from an upper side of the coupling portion 321, 324 to an inside of the coupling portion 321, 324. The alignment hole 323, 326 may be formed through the coupling portion 321, 324, and may be connected to the insertion guide 322, 325. The alignment hole 323, 326 may be elongated horizontally. The insertion guide 322, 325 and the alignment hole 323, 326 may be formed by cutting out the coupling portion 321, 324 of the vertical plate 320 in the up-and-down direction.

The vertical plate 320 may be provided with slits 327 formed therethrough. The slits 327 may be arranged on the left and right sides of the coupling portion 321, 324. A reinforcing pressed portion 315 may be formed on a corner of the vertical plate 320 and the horizontal plate 310. The reinforcing pressed portion 315 may extend from the vertical plate 320 to the horizontal plate 310.

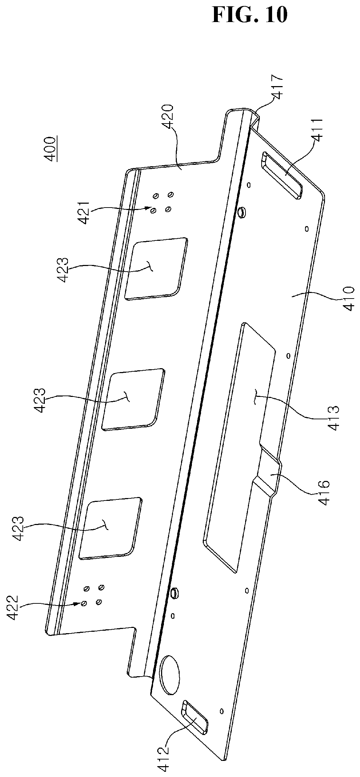

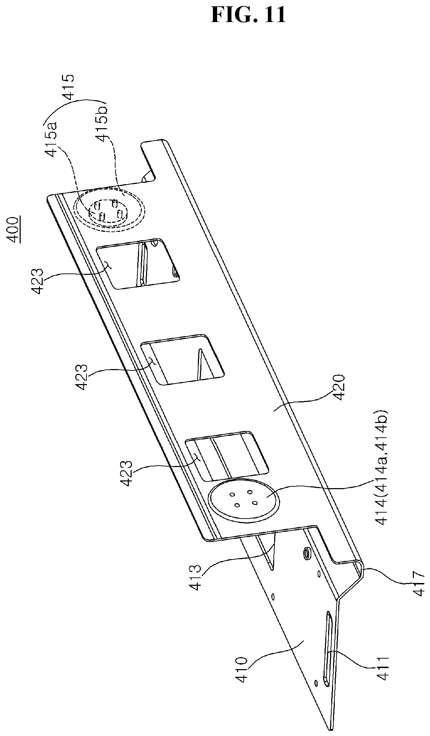

Referring to FIGS. 10 and 11, the lower bracket assembly B1 (see FIG. 8) may include a front bracket 400. The front bracket 400 may be referred to as an inner bracket 400. The front bracket 400 may include a horizontal plate 410 and a vertical plate 420. The vertical plate 420 may be connected to the horizontal plate 410 while being bent from the horizontal plate 410. A flat (or planar) surface of the vertical plate 420 may be perpendicular to a flat surface of horizontal plate 410.

The horizontal plate 410 may be an elongated plate. The horizontal plate 410 may include a support protrusion (411, 412). A plurality of support protrusions 411 and 412 may be provided. The plurality of support protrusions 411 and 412 may be formed while being respectively adjacent to edges at both ends in a longitudinal direction of the horizontal plate 410. The support protrusion 411, 412 may be formed by pressing the horizontal plate 410. The support protrusion 411, 412 may protrude from a lower surface of the horizontal plate 410.

The horizontal plate 410 may have an opening 413. The opening 413 may be formed through the upper and lower surfaces of the horizontal plate 410 between a pair of support protrusions 411 and 412. The opening 413 may have a quadrangular shape elongated in the longitudinal direction of the horizontal plate 410. The opening 413 may be referred to as an upper heat dissipation hole 413 or a second heat dissipation hole 413.

The vertical plate 420 may include a hook coupling portion (421, 422). The hook coupling portion (421, 422) may be provided in plurality. Openings 423 of the vertical plate 420 may be positioned between a pair of hook coupling portions 421 and 422. The hook coupling portion 421, 422 may be formed through the vertical plate 420.

A hook (414, 415) may be fixed to the hook coupling portion 421, 422 of the vertical plate 420. The hook (414, 415) may be provided in plurality. A pair of hooks 414 and 415 may be fixed to the pair of hook coupling portions 421 and 422, respectively. The hook 414, 415 may include a neck 414a, 415a and a head 414b, 415b. The neck 414a, 415a may have a cylindrical shape, and the head 414b, 415b may have a disk shape. A diameter of the head 414b, 415b may be greater than a diameter of the neck 414a, 415a.

The front bracket 400 may include a trench 417. The trench 417 may define a corner of the horizontal plate 410 and the vertical plate 420. The trench 417 may be formed by being lowered or recessed from the upper surface of the horizontal plate 410, and may be connected to the vertical plate 420.

The horizontal plate 410 may be provided with a front support portion 416. The front support portion 416 may be formed by pressing the horizontal plate 410 from the top to the bottom. The front support portion 416 may be formed at the front of the opening 413.

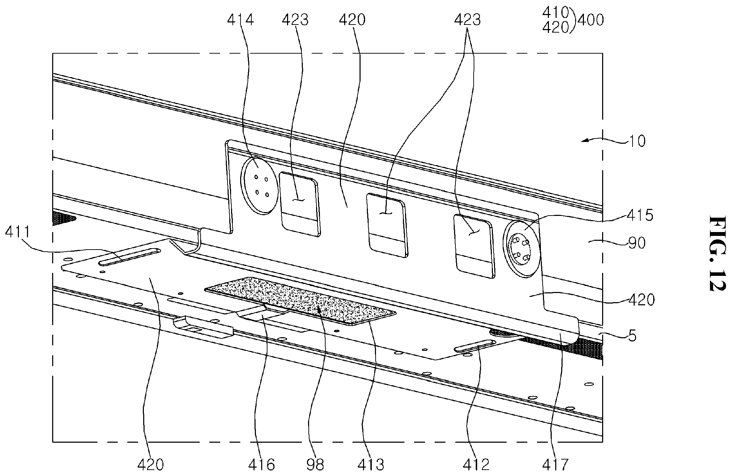

Referring to FIGS. 12 to 15, the front bracket 400 may support a lower surface (or bottom) of the housing 90 or may be coupled or fixed to the lower surface of the housing 90. The front bracket 400 may support the middle frame 5 on which the housing 90 is placed or may be coupled or fixed to a lower surface (or bottom) of the middle frame 5. The horizontal plate 420 of the front bracket 400 may be coupled or fixed to the lower surface of the housing 90 or the lower surface of the middle frame 5.

The second heat dissipation hole 413 of the front bracket 400 may correspond to a heat dissipation outlet 98 formed in the lower surface of the housing 90.

The front bracket 400 may be coupled to the rear bracket 300. The horizontal plate 310 of the rear bracket 300 may support the horizontal plate 410 of the front bracket 400 or may be in contact with the horizontal plate 410 of the front bracket 400. The hook 414, 415 fixed to the vertical plate 420 of the front bracket 400 may be inserted into the alignment hole 323, 326 through the insertion guide 322, 325 provided on the vertical plate 310 of the rear bracket 300. The front bracket 400 may move slightly in the left-and-right direction while being coupled to the rear bracket 300.

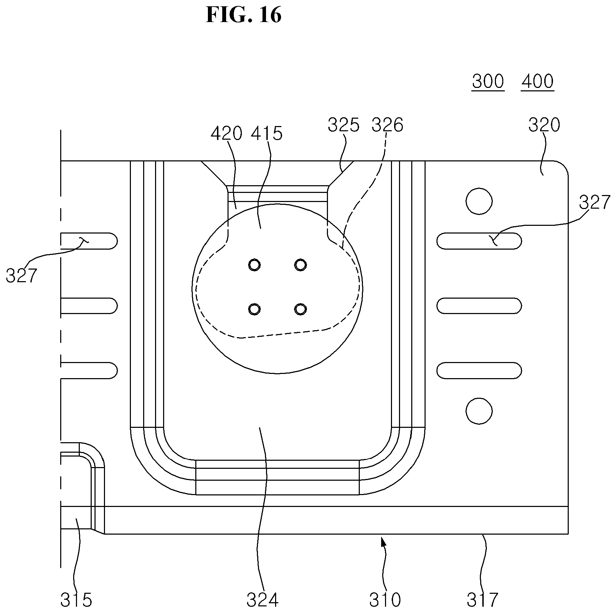

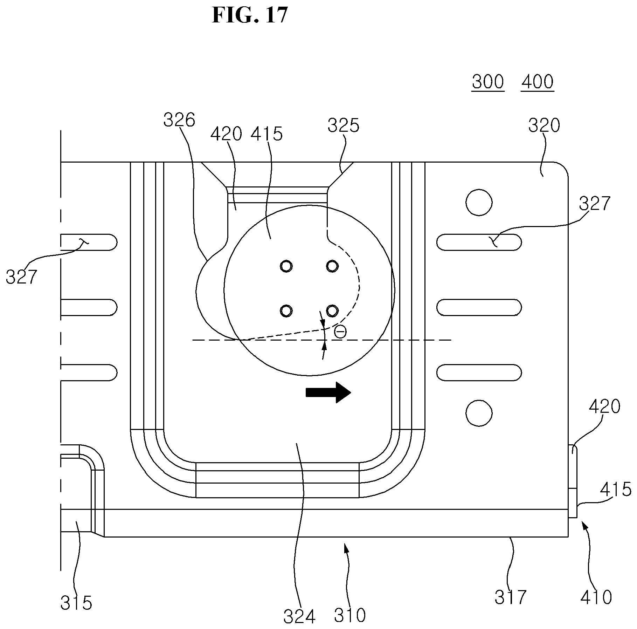

Referring to FIGS. 16 and 17, the hook 414, 415 that is inserted into the alignment hole 323, 326 through the insertion guide 322, 325 provided on the vertical plate 320 of the rear bracket 300 may move in the left-and-right direction relative to the alignment hole 323, 326. A lower side of the alignment hole 323, 326 may be inclined with respect to the horizontal plate 310 of the rear bracket 300. For example, when the front bracket 400 moves to the left or right on the rear bracket 300, the hook 414, 415 may move in an upper left direction or an upper right direction on the alignment hole 323, 326 of the rear bracket 300.

When the front bracket 400 moves in the left-and-right direction relative to the rear bracket 300, the hook 414, 415 and/or the front bracket 400 moves in the left-and-right direction while drawing an arc with respect to a center of the display device 1 (see FIG. 1) to thereby adjust leveling of the display panel 1 (see FIG. 1). For example, an angle theta (θ) that the front bracket 400 makes with the rear bracket 300, namely, an angle theta (θ) that the lower side of the alignment hole 323, 326 makes with the horizontal plate 310 may be 0.5 to 0.8°. As another example, an angle theta (θ) that the front bracket 400 makes with the rear bracket 300, namely, an angle theta (θ) that the lower side of the alignment hole 323, 326 makes with the horizontal plate 310 may be 0.6 to 0.7°.

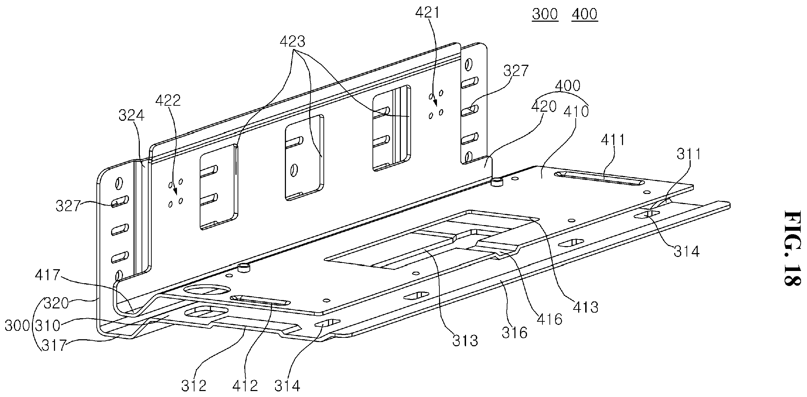

Referring to FIG. 18, the front bracket 400 may be positioned on the rear bracket 300. The horizontal plate 410 of the front bracket 400 may face the horizontal plate 310 of the rear bracket 300. The vertical plate 420 of the front bracket 400 may face the vertical plate 320 of the rear bracket 300. The trench 417 of front bracket 400 may be inserted into the trench 317 of the rear bracket 300.

The first heat dissipation hole 313 may be disposed to correspond to the second heat dissipation hole 413. The support protrusion 411, 412 of the front bracket 400 may correspond to the inclined portion 311, 312 of the rear bracket 300. When the front bracket 400 is laid in an overlapping manner on the rear bracket 300, the support protrusion 411, 412 of the horizontal plate 410 of the front bracket 400 may be supported by the inclined portion 311, 312 of the horizontal plate 310 of the rear bracket 300. The support portion 416 of the horizontal plate 410 of the front bracket 400 may be supported by the horizontal plate 310 of the rear bracket 300. The horizontal plate 410 of the front bracket 400 may maintain a distance with the horizontal plate 310 of the rear bracket 300.

The vertical plate 320 of the rear bracket 300 may be exposed at the front through the openings 423 of the vertical plate 420 of the front bracket 400. As both sides of the vertical plate 420 of the front bracket 400 are cut out, both sides of the vertical plate 320 of the rear bracket 300 may be exposed at the front.

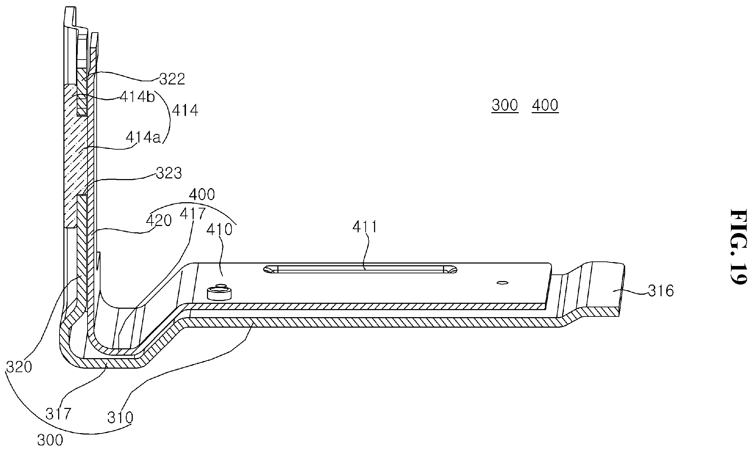

Referring to FIGS. 19 to 22, the support protrusion 411, 412 may be supported by or in contact with the inclined portion 311, 312 on the inclined portion 311, 312. The support protrusion 411, 412 may be referred to as a support rib 411, 412, a frictional rib 411, 412, a side rib 411, 412, or a side protrusion 411, 412. The support protrusion 411, 412 may extend in a width direction of the horizontal plate 410 of the front bracket 400. The support protrusion 411, 412 may move on the inclined portion 311, 312. The contact between the support protrusion 411, 412 and the inclined portion 311, 312 may cause a change in distance defined by the horizontal plate 410 of the front bracket 400 and the horizontal plate 310 of the rear bracket 300.

The inclined portion 311, 312 may extend in a width direction of the horizontal plate 310 of the rear bracket 300. With respect to a direction intersecting a longitudinal direction of the inclined portion 311, 312, the inclined portion 311, 312 may protrude from the horizontal plate 310 of the rear bracket 300 toward the horizontal plate 410 of the front bracket 400. The inclined portion 311, 312 may have a height that gradually increases outward of the horizontal plate 310 of the rear bracket 300.

When the front bracket 400 moves in the left-and-right direction on the rear bracket 300, the support protrusion 411, 412 may move on the inclined portion 311, 312. As the support protrusion 411, 412 goes over the inclined portion 311, 312, the front bracket 400 may be tilted with respect to the rear bracket 300. The front bracket 400 may move in an arc with respect to a central portion of the display device 1 (see FIG. 1), allowing fine adjustment of the position of the front bracket 400 relative to the rear bracket 300.

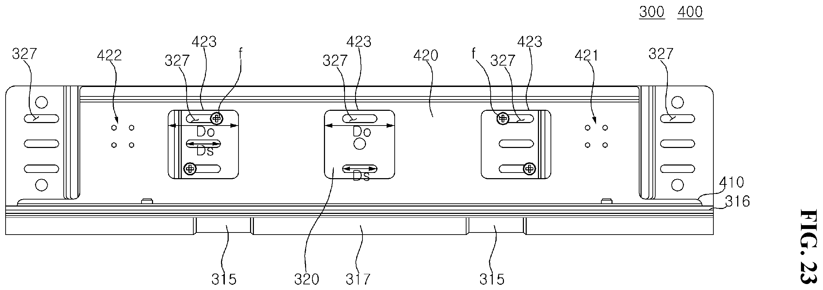

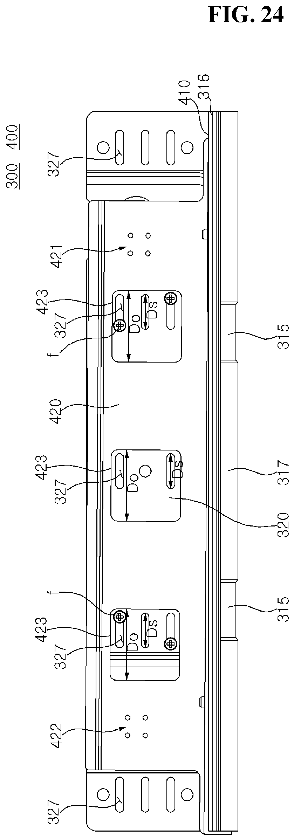

Referring to FIGS. 23 and 24, the openings 423 may have a quadrangular shape. A width Do of each of the openings 423 may be greater than a length Ds of each of the slits 327. A fastening member f may be inserted into the slit 327. The fastening member f inserted into the slit 327 may secure the rear bracket 300 to the wall W (see FIGS. 6 and 7). Even when the front bracket 400 moves to the left or right relative to the rear bracket 300, the slits 327 of the rear bracket 300 may be exposed at the front through the openings 423 of the front bracket 423.

After the rear bracket 300 is fixed to a wall surface by inserting the fastening member f into the slits 327 of the rear bracket 300, even when the front bracket 400 moves in the left-and-right direction relative to the rear bracket 300, interference between the front bracket 400 and the rear bracket 300 may be prevented, and an insertion length of the fastening member f may be adjusted.

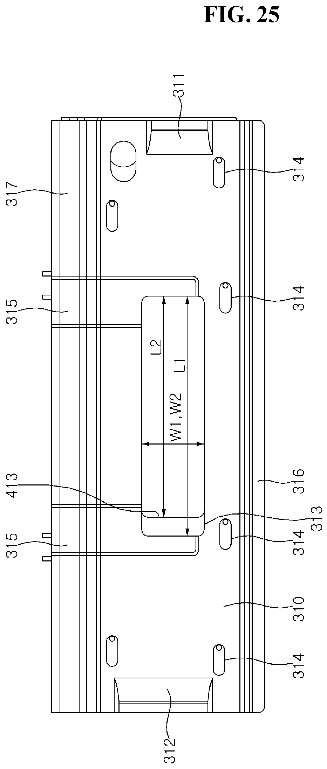

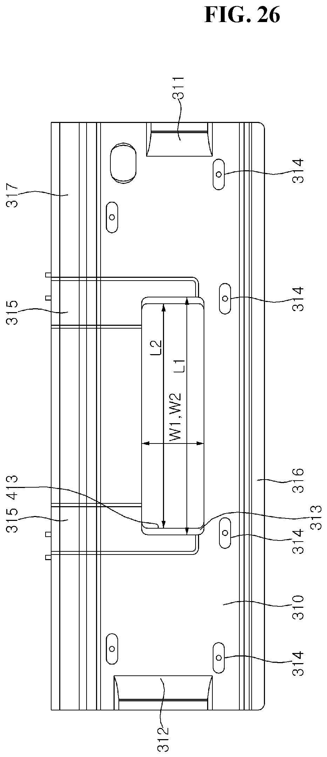

Referring to FIGS. 25 and 26, the first heat dissipation hole 313 may correspond to the second heat dissipation hole 413. The first heat dissipation hole 313 and/or the second heat dissipation hole 413 may have a rectangular shape. A width W1 of the first heat dissipation hole 313 may correspond to a width W2 of the second heat dissipation hole 413. A length L1 of the first heat dissipation hole 313 may be greater than a length L2 of the second heat dissipation hole 413.

When the front bracket 400 moves in the left-and-right direction on the rear bracket 300, the second heat dissipation hole 413 moves in the left-and-right direction relative to the first heat dissipation hole 313, so that the second heat dissipation hole 413 may move over to the left or right of the first heat dissipation hole 313 (see FIG. 25).

When the front bracket 400 moves in the left-and-right direction on the rear bracket 300, the second heat dissipation hole 413 may move in the left-and-right direction relative to the first heat dissipation hole 313. When the front bracket 400 is located at a center of the rear bracket 300, the second heat dissipation hole 413 may be positioned inside the first heat dissipation hole 313 (see FIG. 26).

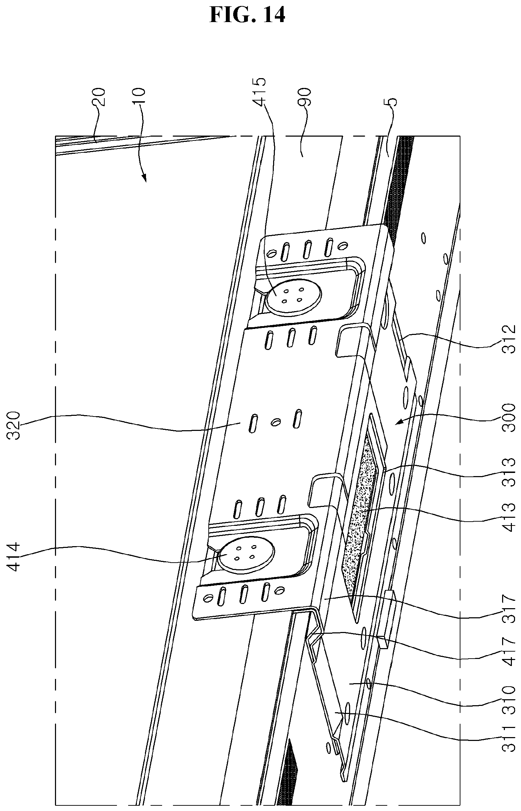

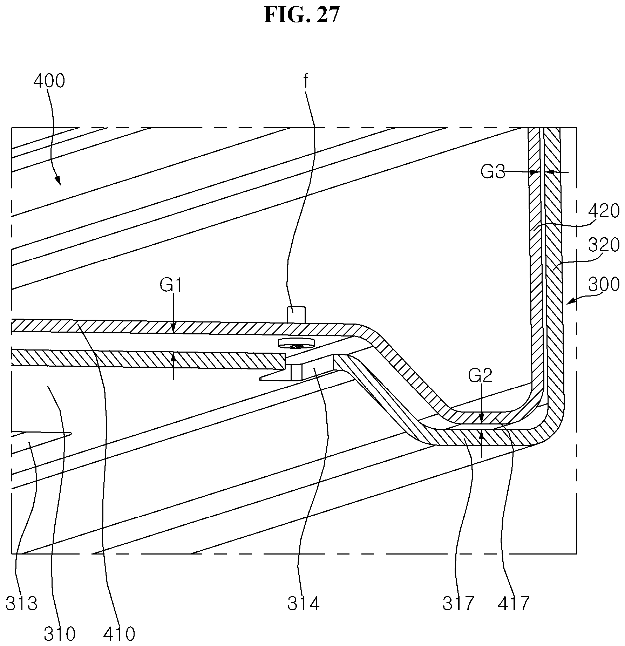

Referring to FIG. 27, the long hole 314 may be formed in the horizontal plate 310 of the rear bracket 300. The long hole 314 may be elongated in a left-and-right direction of the horizontal plate 310. A fastening member f may be coupled to the horizontal plate 410 of the front bracket 400. The fastening member f may be coupled to the housing 90 (see FIG. 14) of the display device 1 (see FIG. 1).

The fastening member f may be inserted from the lower surface toward the upper surface of the horizontal plate 410 of the front bracket 400. The long hole 314 of the rear bracket 300 may correspond to the fastening member f of the front bracket 400. When the front bracket 400 moves in the left-and-right direction on the rear bracket 300, the fastening member f may move relative to the long hole 314.

A first gap G1 may be formed between the horizontal plate 310 of the rear bracket 300 and the horizontal plate 410 of the front bracket 400. A second gap G2 may be formed between the trench 317 of the rear bracket 300 and the trench 417 of the front bracket 400. A third gap G3 may be formed between the vertical plate 320 of the rear bracket 300 and the vertical plate 420 of the front bracket 400. The second gap G2 may be greater than the third gap G3. The first gap G1 may be greater than the second gap G2. Accordingly, the bracket assembly 300, 400 may support the display device 1 (see FIGS. 6 and 7) with heavy weight.

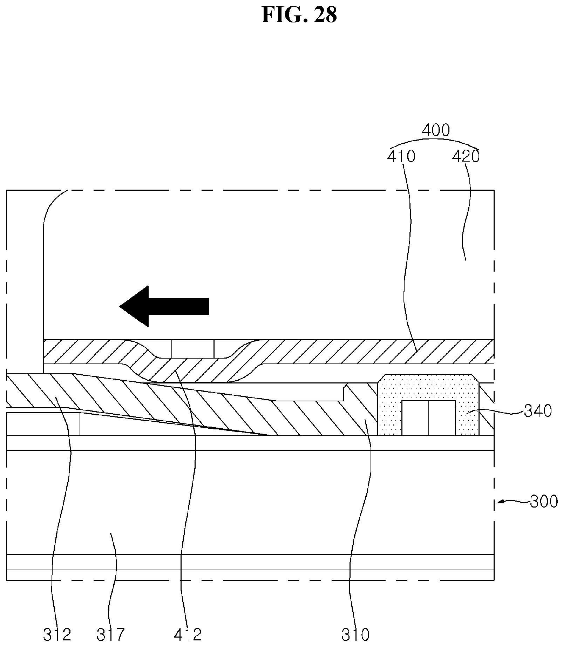

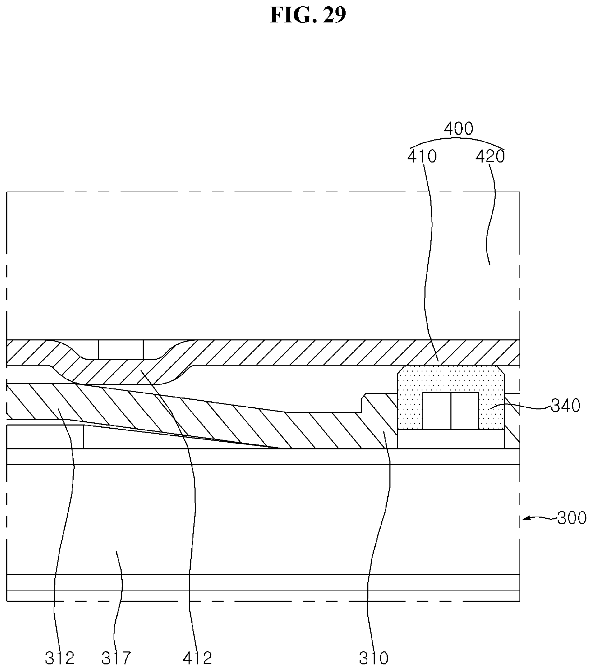

Referring to FIGS. 28 and 29, when the front bracket 400 moves in the left-and-right direction on the rear bracket 300, the support protrusion 411, 412 of the horizontal plate 410 of the front bracket 400 may go over the inclined portion 311, 312 of the horizontal plate 310. The support protrusion 411, 412 may not slip off from the inclined portion 311, 312 due to friction. Depending on the load applied to the front bracket 400 and/or the rear bracket 300, the support protrusion 411, 412 may slip off from the inclined portion 311, 312.

A stopper 340 may be coupled to the horizontal plate 310 of the rear bracket 300. The stopper 340 may pass through the upper surface of the horizontal plate 310 of the rear bracket 300 and protrude to the top of the horizontal plate 310. For example, the stopper 340 may be made of synthetic resin or rubber.

When the support protrusion 411, 412 of the front bracket 400 moves to a top end of the inclined portion 311, 312 as the front bracket 400 moves in the left-and-right direction on the rear bracket 300, the stopper 340 may be leveled to support the lower surface of the horizontal plate 410 of the front bracket 400 or contact the lower surface of the horizontal plate 410. Thus, it is possible to prevent a change in position due to the front bracket 400 slipping off from the rear bracket 300.

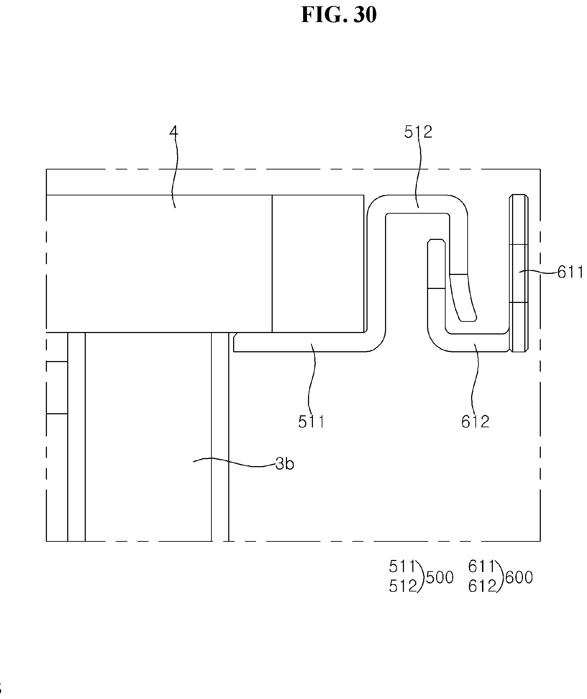

Referring to FIG. 30, the upper bracket assembly B2 may include a wall mount 600 and a hook bracket 500. The wall mount 600 may be fixed on the wall W (see FIG. 6). The wall mount 600 may include a mount fixer 611 and a mount hook 612. The mount fixer 611 may be fixed on the wall W, and the mount hook 612 may be connected to the mount fixer 611.

The hook bracket 500 may include a hook fixer 511 and a connecting hook 512. The hook fixer 511 may be fixed to the top frame 4. The connecting hook 512 may be connected to the hook fixer 511. The connecting hook 512 of the hook bracket 500 may be engaged with the mount hook 612 of the wall mount 612. Thus, it is possible to prevent the display device 1 (see FIG. 6) from being turned over.

Referring to FIGS. 1 to 30, a bracket assembly (300, 400) may include: a front bracket 400 to support a display device 1 including a display panel; and a rear bracket 300 to support the front bracket 400. The front bracket 400 may include: a horizontal plate 410 to support a bottom of the display device 1; a vertical plate 420 bent and extending from the horizontal plate 410 of the front bracket 400 so as to be positioned at a rear of the display device 1; and a hook 414, 415 fixed to a rear surface of the vertical plate 420 of the front bracket 400. The rear bracket 300 may include: a horizontal plate 310 to support the horizontal plate 410 of the front bracket 400; a vertical plate 320 bent and extending from the horizontal plate 310 of the rear bracket 300, the vertical plate 320 facing the vertical plate 420 of the front bracket 400; and a coupling portion 321, 324 formed on the vertical plate 320 of the rear bracket 300 and configured to allow the hook 414, 415 of the front bracket 400 to be inserted therein so as to be moveable in a left-and-right direction.

The coupling portion 321, 324 of the rear bracket 300 may include: an insertion guide 322, 325 formed by cutting out a portion of the vertical plate 320 of the rear bracket 300; and an alignment hole 323, 326 formed through the vertical plate 320 of the rear bracket 300 and connected to the insertion guide 322, 325. The hook 414, 415 of the front bracket 400 may be movable relative to the alignment hole 323, 326 of the rear bracket 300.

The front bracket 400 may include a support protrusion 411, 412 protruding from the horizontal plate 410 of the front bracket 400 toward the horizontal plate 310 of the rear bracket 300. The rear bracket 300 may include an inclined portion 311, 312 protruding from the horizontal plate 310 of the rear bracket 300 toward the horizontal plate 410 of the front bracket 400. The inclined portion 311, 312 may be aligned with the support protrusion 411, 412, so that the inclined portion 311, 312 may support the support protrusion 411, 412 when the front bracket 400 moves relative to the rear bracket 300.

The rear bracket 300 may include a stopper 340 that is adjacent to the inclined portion 311, 312 and coupled to the horizontal plate 310 of the rear bracket 300. The stopper 340 may be levelled on the horizontal plate 310 of the rear bracket 300 to be away from or closer to the horizontal plate 410 of the front bracket 400.

The rear bracket 300 may include a first heat dissipation hole 313 formed through the horizontal plate 310 of the rear bracket 300. The front bracket 400 may include a second heat dissipation hole 413 formed through the horizontal plate 410 of the front bracket 400 and aligned with the first heat dissipation hole 313.

The display device 1 may include: a display 10 including the display panel; a side frame 20 to which the display 10 is coupled; and a housing 90 to which the display 10 and the side frame 20 are coupled, the housing 90 including a heat dissipation outlet 98. The first heat dissipation hole 313 and the second heat dissipation hole 413 may be aligned with the heat dissipation outlet 98.

The rear bracket 300 may include a reinforcing pressed portion 315 that connects the horizontal plate 310 of the rear bracket 300 and the vertical plate 320 of the rear bracket 300, the reinforcing pressed portion 315 being formed by pressing the horizontal plate 310 of the rear bracket 300 and the vertical plate 320 of the rear bracket 300.

The rear bracket 300 may include a first trench 317 that defines a corner of the horizontal plate 310 of the rear bracket 300 and the vertical plate 320 of the rear bracket 300 and forms a step descending from the horizontal plate 310 of the rear bracket 300. The front bracket 400 may include a second trench 417 that defines a corner of the horizontal plate 410 of the front bracket 400 and the vertical plate 420 of the front bracket 400 and forms a step descending from the horizontal plate 410 of the front bracket 400. The second trench 417 may be inserted into the first trench 317.

The coupling portion 321, 324 may be formed by pressing the vertical plate 320 of the rear bracket 300 toward the vertical plate 420 of the front bracket 400. The hook 414, 415 may include: a neck 414a, 415a fixed to a rear surface of the vertical plate 320 of the rear bracket 300; and a head 414b, 415b connected to the neck 414a, 415a and positioned in a recessed step formed by the coupling portion 321, 324.

The neck 414a, 415a of the hook 414, 415 may be positioned in the alignment hole 323, 326 of the coupling portion 321, 324 so as to be moveable on the alignment hole 323, 326.

A display device 1 may include: a display 10 including a transparent display panel configured to display an image and a transparent panel to which the transparent display panel is coupled; a side frame 20 to which the display 10 is coupled; a housing 90 to which the side frame 20 is coupled; a middle frame 5 to support the housing 90; a top frame 4 disposed opposite the middle frame 5 with respect to the display 10; a plurality of vertical frames 3a and 3b to connect the top frame 4 and the middle frame 5; a front bracket 400 to support the middle frame 5; and a rear bracket 300 to which the front bracket 400 is coupled.

Certain embodiments or other embodiments of the disclosure described above are not mutually exclusive or distinct from each other. Any or all elements of the embodiments of the disclosure described above may be combined or combined with each other in configuration or function.

For example, a configuration "A" described in one embodiment of the disclosure and the drawings, and a configuration "B" described in another embodiment of the disclosure and the drawings may be combined with each other. Namely, although the combination between the configurations is not directly described, the combination is possible except in the case where it is described that the combination is impossible.

The above detailed description is to be construed in all aspects as illustrative and not restrictive. The scope of the present disclosure should be determined by reasonable interpretation of the appended claims, and all changes coming within the equivalency range of the present disclosure are intended to be embraced in the scope of the present disclosure.

## Claims

1. A bracket assembly(300,400) for supporting a display device(1), the bracket assembly(300,400) comprising:
a front bracket(400) and a rear bracket,
wherein the front bracket(400) comprises:
a front horizontal plate(410) configured to support a bottom of the display device(1);
a front vertical plate(420) angled and extending from the front horizontal plate(410) so as to be positioned at a rear of the display device(1); and
a hook(414,415) at a rear surface of the front vertical plate(420), and
wherein the rear bracket(300) comprises:
a rear horizontal plate(310) configured to support the front horizontal plate(410);
a rear vertical plate(320) angled and extending from the rear horizontal plate(310) so as to face the front vertical plate(420); and
a coupling portion(321,324) formed at the rear vertical plate(320) and configured to allow the hook(414,415) of the front bracket(400) to be inserted therein so as to be moveable in a left-and-right direction.

2. The bracket assembly of claim 1, wherein the coupling portion(321,324) comprises:
an insertion guide(322,325) defined by a cut out portion of the rear vertical plate(320); and
an alignment hole(323,326) defined at the rear vertical plate(320) to be in communication with the insertion guide(322,325), and
wherein the alignment hole(323,326) is defined such that the hook(414,415) is movable in the alignment hole(323,326) of the rear bracket(300) in the left-and-right direction.

3. The bracket assembly of claim 1 or 2, wherein:
the front bracket(400) further comprises a support protrusion(411,412) protruding from the front horizontal plate(410);
the rear bracket(300) further comprises an inclined portion(311,312) protruding from the rear horizontal plate(310); and
the inclined portion(311,312) is aligned with the support protrusion(411,412) such that the inclined portion(311,312) supports the support protrusion(411,412) as the front bracket(400) moves relative to the rear bracket(300).

4. The bracket assembly of claim 3, wherein the rear bracket(300) further comprises a stopper(340) adjacent to the inclined portion(311,312) and coupled to the rear horizontal plate(310) to support a lower surface of the front horizontal plate(410).

5. The bracket assembly of any one of claims 1 to 4, wherein:
the rear bracket(300) further comprises a first heat dissipation hole(313) formed at the rear horizontal plate(310);
the front bracket(400) further comprises a second heat dissipation hole(413) formed at the front horizontal plate(410); and
the second heat dissipation hole(413) is aligned with the first heat dissipation hole(313).

6. The bracket assembly of claim 5, wherein the first heat dissipation hole(313) and the second heat dissipation hole(413) are configured to be aligned with a heat dissipation outlet(98) disposed at a side of a housing of the display device.

7. The bracket assembly of any one of claims 1 to 6, wherein the rear bracket(300) further comprising a reinforcing pressed portion(315) at a connection of the rear horizontal plate(310) and the rear vertical plate(320) which is formed by pressing portions of the rear horizontal plate(310) and the rear vertical plate(320).

8. The bracket assembly of any one of claims 1 to 7, wherein:
the rear bracket(300) further comprises a first trench(317) at a corner of the rear horizontal plate(310) and the rear vertical plate(320) which forms a depressed step from a surface of the rear horizontal plate(310),
the front bracket(400) further comprises a second trench(417) at a corner of the front horizontal plate(410) and the front vertical plate(420) which forms a depressed step from a surface of the front horizontal plate(410), and
the second trench(417) is configured to be accommodated in the first trench(317).

9. The bracket assembly of claim 8, wherein:
a first gap is formed between the rear horizontal plate(310) and the front horizontal plate(410);
a second gap is formed between the first trench(317) and the second trench(417); and
a third gap is formed between the rear vertical plate(320) and the front vertical plate(420), and
the second gap is greater than the third gap, and the first gap is greater than the second gap.

10. The bracket assembly of any one of claims 2 to 9, wherein the coupling portion(321,324) protrudes forward from the rear vertical plate(320) toward the front vertical plate(420), and
wherein the hook(414,415) comprises:
a neck(414a,415a) fixed to the rear surface of the front vertical plate(320); and
a head(414b,415b) connected to the neck(414a,415a) and configured to be accommodated in a space formed by the forward protrusion of the coupling portion(321,324).

11. The bracket assembly of claim 10, wherein the neck(414a,415a) of the hook(414,415) is moveable in the alignment hole(323,326).

12. A display device (1) comprising:
a display(10) including a transparent display panel configured to display an image and a transparent panel to which the transparent display panel is coupled;
a side frame(20) to which the display(10) is coupled;
a housing(90) to which the side frame(20) is coupled;
a middle frame(5) configured to support the housing(90);
a top frame(4) disposed opposite the middle frame(5) with respect to the display(10);
a plurality of vertical frames(3a,3b) connecting the top frame(4) and the middle frame(5);
a front bracket(400) configured to support the middle frame(5); and
a rear bracket(300) to which the front bracket(400) is coupled.

13. The display device of claim 12, wherein the front bracket(400) comprises:
a front horizontal plate(410) configured to support a bottom of the middle frame(5);
a front vertical plate(410) angled and extending from the front horizontal plate(410) so as to be positioned at a rear of the housing; and
a hook(414,415) at a rear surface of the front vertical plate(420); and
wherein the rear bracket(300) comprises:
a rear horizontal plate(310) configured to support the front horizontal plate(410);
a rear vertical plate(320) angled and extending from the rear horizontal plate(310) so as to face the front vertical plate(420); and
a coupling portion(321,324) formed at the rear vertical plate(320) and configured to allow the hook(414,415) of the front bracket(400) to be inserted therein so as to be moveable in a left-and-right direction.

14. The display device of claim 13, wherein the coupling portion(321,324) comprises:
an insertion guide(322,325) defined by a cut out portion of the rear vertical plate(320); and
an alignment hole(323,326) defined at the rear vertical plate(320) to be in communication with the insertion guide(322,325), and
wherein the alignment hole(323,326) is defined such that the hook(414,415) is movable in the alignment hole(323,326) of the rear bracket(300) in the left-and-right direction.

15. The display device of claim 13 or 14, wherein:
the front bracket(400) further comprises a support protrusion(411,412) protruding from the front horizontal plate(410);
the rear bracket(300) further comprises an inclined portion(311,312) protruding from the rear horizontal plate(310); and
the inclined portion(311,312) is aligned with the support protrusion(411,412) such that the inclined portion(311,312) supports the support protrusion(411,412) as the front bracket(400) moves relative to the rear bracket(300).
